# EUROPEAN PATENT SPECIFICATION

(11) **EP 3 640 771 B1**
(45) Date of publication and mention of the grant of the patent: **25.11.2026**
(21) Application number: 19201217.7
(22) Date of filing: 02.10.2019
(51) Int. Cl.: G06F 3/01, A63F 13/214, A63F 13/24, G06F 3/0354, G06F 3/044

(54) **SENSOR DEVICE AND METHOD**
SENSORVORRICHTUNG UND -VERFAHREN
DISPOSITIF DE CAPTEUR ET PROCÉDÉ

(30) Priority: 15.10.2018 GB 201816785
(43) Date of publication of application: 22.04.2020
(73) Proprietor: Tangi0 Limited, London SW4 7NQ (GB)
(72) Inventor: LIN, Chia-hung, London, SW2 1DX (GB); KONG, Ming, London, SW11 3TP (GB); GUO, Liucheng, London, E14 9BU (GB); CORREA, Ilan Johan Eduardo Olivarez, London, NW1 1PH (GB)
(74) Representative: Barker Brettell LLP

(56) References cited:
- WO-A1-2016/206819
- WO-A1-2017/150127
- US-A1- 2014 036 428
- US-A1- 2016 209 920
- US-A1- 2018 067 545

## Description

### Technical Field

This invention relates generally to a sensor device for determining a position of an operator's finger/hand and, particularly, but not exclusively, to a handheld or hand-mountable sensor device. The invention also relates to a method of manufacturing a sensor device.

### Background to the Invention

Handheld remote controllers have traditionally translated human hand and/or finger movement into input/command signals through the mechanical movement of switches, buttons and joysticks. The commands are delivered from the user to a computer processor, and finally to a device to provide a visual and/or sound output such as switching TV channels or tuning the volume of a speaker. Increasingly intricate and immersive digital technologies and software environments (e.g. virtual reality environments) have created an increasing demand for advanced sensing and control technologies that can understand nuanced human hand and finger movement (e.g. gestures) in order to achieve natural and intuitive human-machine interactions. This has created a trend of moving away from traditional controller typologies such as buttons, scrolls and joysticks.

Capacitive touch sensing is a technology now commonly employed in consumer electronic controller devices. Based on the principle of capacitive coupling, capacitive sensors produce a signal change that reflects the contact (touch), location, coverage area and/or displacement of a conductive object (e.g. a human finger). Commonly used capacitive touch sensors comprise printed metallic materials on thin substrates that form a network or grid of sensing electrodes. The printed electrode pattern can be customised to meet different requirements of the device and outer isolation material configurations (see e.g, US8077154B2). However, the need for high fidelity gestural controllers has posed challenges to traditional capacitive sensing manufacturing methods. For example, a capacitive sensor requires a non-conductive isolation layer between the sensor electrode and the human finger(s) to provide protection, set up a capacitance and limit noise. Traditionally, the isolation layer is often required to be rigid and uniform in thickness. This means any touch sensing surface constructed with a 3D (three dimensional) profile needs the underlying substrate and printed electrodes to conform to the 3D profile. Flexible printed circuitry can meet this need by bending portions of the substrate to attach to the back side of the outer isolation layer. However, such bending is limited to be in one direction only due to the nature of the flexible substrate materials (e.g. PET plastics). Technologies such as vacuum formed printed electronics (e.g. US9801273B2) can form 3D profiled substrates onto which printed metallic electrodes are applied before or after forming, but such vacuum formed substrates are limited by the 3D profiles' depth due to the limited flexibility of the electrode materials used.

Aside from applications in mere control, controller technologies that can determine human hand and finger movements may have applications in sign language translation and in the medical field, such as in mirror therapy.

Mirror therapy traditionally uses a mirror to create an illusion, tricking the brain into believing that a part of the body currently affected by motor issues is no longer affected. However, there has been promising research that demonstrates the potential for mirror therapy in non-immersive virtual reality (e.g. Non-immersive Virtual Reality Mirror Visual Feedback Therapy and Its Application for the Treatment of Complex Regional Pain Syndrome: An Open-Label Pilot Study, 2010). As such, controllers capable of projecting finger movement into a virtual environment would enable mirror therapy to become more immersive and interactive. People with motor difficulties under recovery would also be able to wear a device and it would be able to gather more useful data regarding the movement capability and squeezing capability of patients.

Currently, sign language translation to non-sign language users requires a camera and a computer system. The camera must be pointed at the 'signer' to understand their gestures and movements, limiting the range of hand/arm movement to the field of view to the camera. A gestural sensing handheld controller would enable free gesture and movement to the 'signer' and completely circumvent the necessity of a camera-based device to enable detection and translation.

With the mentioned problems and market needs, US2017/0102775A1 and US2018/0077976 show hand-worn controllers in the form of wearable gloves which translate movement of hands and fingers into input signals based on the deformation of the gloves. These controllers can offer high level gestural control functions through the use of force sensors and bend sensors to detect finite movement of hands and fingers.

There are numerous challenges and limitations of the above mentioned controllers. While they offer additional sensing capabilities compared to conventional handheld controllers (e.g., see US2006/0282873A1), they are costly to manufacture and heavy. Mass production costs are highly sensitive to the materials/components used, number of parts to be assembled and complexity of the products. Known controllers employ rigid plastic housings and a large number of conventional and typically heavy electronic components (e.g. capacitive sensors, tracks, circuit boards etc.) made from relatively costly metallic/semiconducting materials. As such, the component costs are high and the production process can be assembly-intensive, particularly with the use of flexible printed electronics. Modulation of control functions also adds weight as each moving part requires an individually injection-moulded plastic part. **In** addition, a good fit between a glove controller and the user's hand is crucial for its sensing functions, and thus performance can be sub-optimal depending on the fit. With heavy/rigid conventional electronic components embedded in each sensor glove, it is impractical to mass produce gloves for all kinds of hands sizes and proportions. This type of controller may also be cumbersome when users complete daily actions like to typing, grabbing or holding other objects.

US2018/067545A1 discloses apparatuses, systems, and methods for measuring the grasp state, position, or hand pose of a user's hand relative to a device, which could be used as an input for human-machine input, augmented reality, virtual reality, video games, or tele-manipulation. The device includes a plurality of grasp sensors embedded within the device. A kinematic hand model is used in combination with grasp sensing data to estimate a user's hand pose.

WO2017/150127A1 discloses a control apparatus for a device worn on the user's left hand or right hand, wherein the control apparatus acquires prescribed information from the device and, on the basis of the acquired prescribed information, determines whether the device is being worn on the user's left hand or the right hand.

WO2016/206819A1 discloses a sensor device for generating an electrical signal which comprises an electrically conductive material having, at least in part, a three-dimensionally profiled surface. The surface is configured to create a change in said electrical signal in response to movement of a conductive object (e.g. a person's finger) thereacross.

US2016/209920A1 discloses: an apparatus comprises a sensor configured to detect movement and generate movement data related to at least part of a detected movement; a messaging unit configured to create a message that is configured to include movement information based at least in part upon the movement data; a transmitter in data communication with the messaging unit and configured to transmit the message; a touch sensor area configured to send, based at least in part on detection of a touch, an activation signal to the messaging unit; and a housing configured to at least partially enclose at least one of the sensor, the messaging unit, and the transmitter, and including a finger grip configured to secure the housing to a human finger.

US2014036428 A1 describes a method of moulding comprising: patterning one or more electrical layers on a substrate; shaping the patterned substrate into a 3-dimensional contour, wherein the contour including a significant change in gradient in or adjacent to one or more sensing areas of the electrical layer, and over-moulding the shaped substrate, wherein degradation of a trace in the electrical layer at or adjacent to the one or more sensing areas during shaping and/or over-moulding is substantially minimised based on the width of the trace, the thickness or number of layers of the trace, the bending radius of the trace, the material of the trace, and/or a primer over layer on the trace.

Aspects and embodiments of the present invention have been devised with the foregoing in mind.

### Summary of the Invention

According to the invention, there is provided a sensor device for determining a position of an operator's finger and/or hand, as defined in claim 1. Preferred embodiments are defined by the dependent claims. The handle portion may be mountable to or holdable in a said operator's hand for gripping by one or more fingers of said hand. The measurement module may be receivable or mountable within the handle portion.

The term non-metallic conductive material used here and throughout means a material that is not a metal (e.g. gold, silver or aluminium).

The or each touch sensing electrode portion is formed of or comprise a thermo-formable material and is formed by a moulding process. The touch sensing electrode portion(s) may be substantially rigid, pliable and/or deformable. A suitable material for the touch sensing electrode portion(s) may include but is not limited to a conductive plastics, such as conductive acrylonitrile butadiene styrene (ABS) or conductive polyurethane (PU), conductive ethylene vinyl acetate (EVA). Such materials may undergo an injection-moulding/heat-pressing or thermo-forming process.

The use of mouldable non-metallic conductive materials for the touch sensing electrode portion(s) has a number of advantages over conventional sensing technologies using metal electrodes. The material cost and weight is significantly lower than that of conventional metal electrode materials (such as a gold, silver or aluminium). Manufacture/assembly of the sensor device is simplified and the associated manufacture/assembly cost is reduced. In addition, the touch sensing electrode portion(s) can be formed and/or moulded into almost any arbitrary size, shape or three-dimensional (3D) form due to the nature of the moulding process. This has a number of practical and functional advantages:
- The touch sensing electrode portion(s) may conform to the exterior shape of the handle portion regardless of the complexity of the exterior shape. This eliminates the need for flexible printed circuits which can introduce complexity in the electrode arrangement, wiring, and increase wear and tear and assembly costs.
- The touch sensing electrode portion(s) has(have) 3D volumes and can cover larger areas enabling them to be much more sensitive to capacitance changes and produce larger signal changes compared to the typically smaller metal electrode counterparts.
- The size and shape of the or each touch sensing electrode portion can be chosen to tailor e.g. to produce smooth electrical signal changes between a minimum and maximum signal values. This allows the touch sensing electrode portion(s) to sense a wider range of finger/hand movements.
- Overall, the design freedom for the touch sensing electrode portion(s), the electrode arrangement and the sensor device itself are significantly increased.

In addition, e.g. through machine learning software methods, the large 3D touch sensing electrode portion(s) can enable the measurement of not only the distance ("vertical") proximity of a finger/thumb/hand section, but also position - "horizontal finger position - and distribution providing detection of complex and realistic gestures.

### Brief Description of Drawings

In order that the invention can be well understood, embodiments will now be discussed by way of example only with reference to the accompanying drawings, in which:
**Figures 1a and 1b** show illustrations of a sensor device according an embodiment of the invention, mounted to a left hand;
**Figure 2** shows the device of figure 1 with the mounting clip detached;
**Figure 3** shows a left and right hand mounting clip for the device of figure 1;
**Figure 4** shows an example arrangement of sensing electrode in the device of figures 1 to 3;
**Figures 5a-5d** illustrate steps of a method of assembling the device of figure 1 to 4 according to an embodiment of the invention;
**Figures 6a-6c** illustrate the operation of the device; and
**Figures 7a and 7b** show further example sensor devices according to the invention.

It should be noted that the figures are diagrammatic and may not be drawn to scale. Relative dimensions and proportions of parts of these figures may have been shown exaggerated or reduced in size, for the sake of clarity and convenience in the drawings. The same reference signs are generally used to refer to corresponding or similar features in modified and/or different embodiments.

### Detailed Description

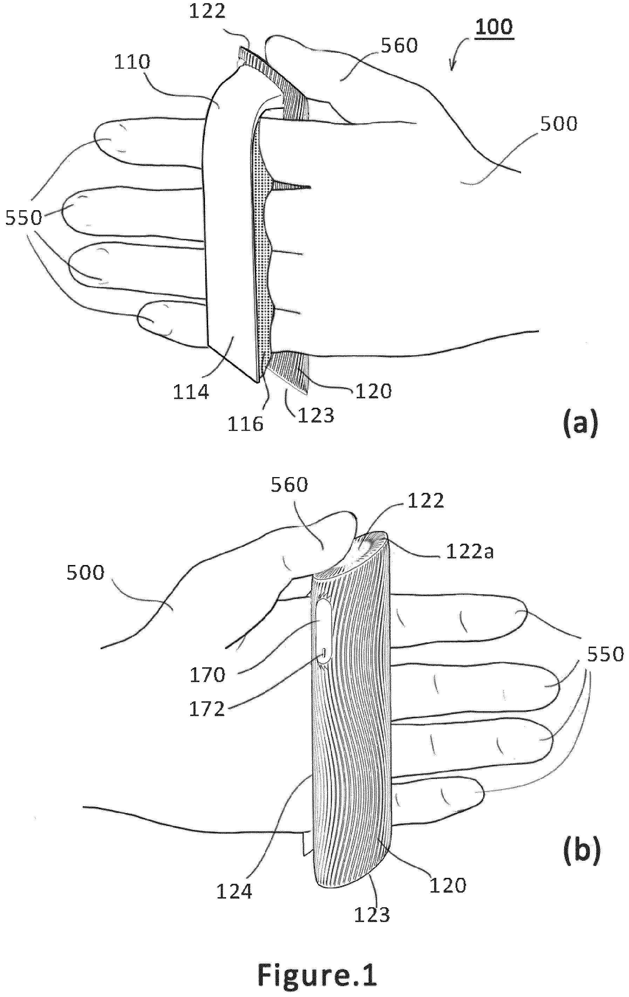

Figures 1a and 1b show an embodiment of a sensor device 100 for determining a position or pose of an operator's finger(s) 550 and/or hand 500. The device 100 is a hand-mountable or hand-held device. The device 100 comprises a handle portion 120 comprising electronic components for determining finger 550/hand 500 positions and a hand mounting portion 110 connectable to the handle portion 120 for mounting the handle portion 120 to or against a user's hand 500, as shown.

The mounting portion 110 is shown in the form of a semi-open clip structure. The mounting portion 110 comprises one end that is attachable to the handle portion 120 at a coupling 112a and another end that extends (when connected to the handle portion 120) from the handle portion 120 around to the back of the hand 500 or fingers 550 to hold or retain the handle portion 120 against the inside of the hand 500 or fingers 550. However, it will be appreciated that the mounting portion 110 may take other forms. For example, alternatively the mounting portion 110 may be coupled to the handle portion 120 at two points to form a closed loop or opening that extends completely around the hand 500 or fingers 550.

The function of the mounting portion 110 is to hold or retain the handle portion 120 in an operating position against the inside of the hand 500 or fingers 550 without the need for the user to physically grip/hold the handle portion 120. This is illustrated in in figures 1a and 1b which shows the device 100 mounted to the operator's hand 500 with the hand 500 and/or fingers 550 in an opening pose/position. The operating position is preferably one where the device 100 is mounted between the first and second knuckles (between the metacarpophalangeal (MCP) joint and the proximal interphalangeal (PIP) joint) of the fingers 550 or on the proximal phalanges, as shown in figures 1a and 1b.

The hand mountable function has several benefits: (i) It enables the device 100 to sense a full range of positions of a user's finger(s) 550 relative to the handle portion 120 between the opening position (as shown in figures 1 and 1b) and the closed position (i.e. fully gripping the handle portion (not shown)); (ii) it helps to maintain the handle portion 120 in the operation position during movement of the finger(s) 550; and (iii) it allows the user to be fully free to move and use their finger(s) 550 to hold and/or pick up other objects, and also complete simple actions/tasks such as typing or the like.

The mounting portion 110 comprises a core structure 114 to support the handle portion 120. The core structure 114 is formed from a substantially tough and flexible material (e.g. acrylonitrile butadiene styrene (ABS)). Optionally, the mounting portion 110 may further comprise a padded or cushioned portion 116, as shown in figure 1a. The padded portion 116 is substantially deformable and arranged, in use, to fill any excess space between the back of the user's hand 500 or finger's 550 and the core structure 114. This may allow the device 100 to fit fingers of different thickness. The padded portion 116 may further be substantially resilient to bias the handle portion 120 towards the user's hand 500 or fingers 550. For example, the padded portion 116 may be formed of or comprise a foam (such as a memory foam or any other high density foam), soft rubber (e.g. neoprene), soft plastic (e.g. thermoplastic elastomer), or ethylene-vinyl acetate (EVA), silicone rubber. The padded portion 116 may further be laminated and/or covered with a fabric material, such as synthetic leather or the like.

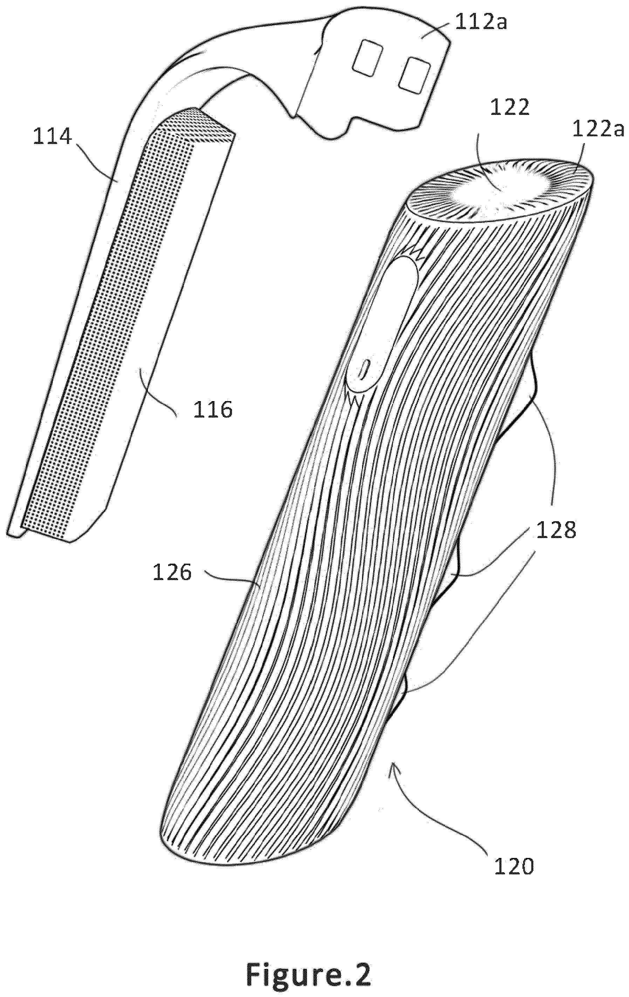

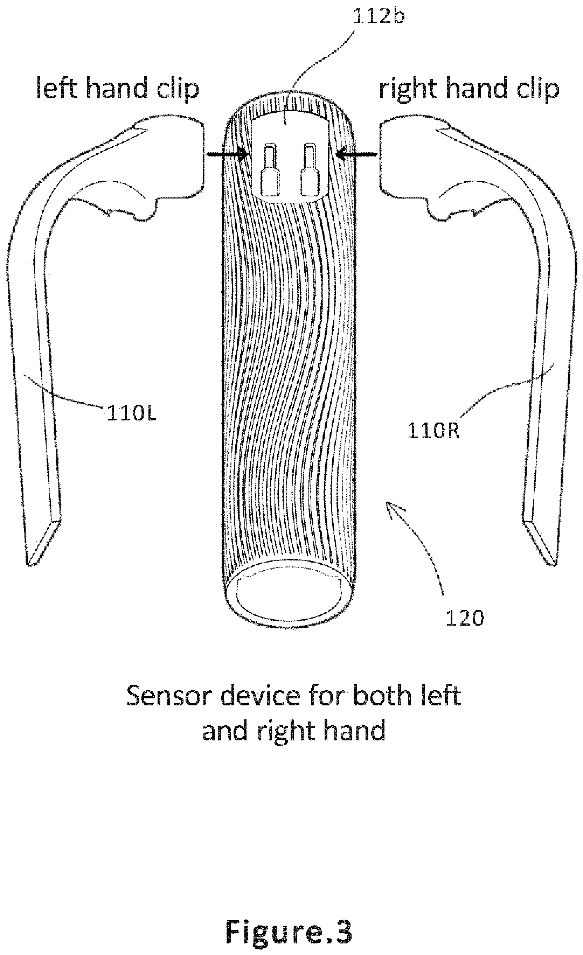

The mounting portion 110 is attachable/detachable from the handle portion 120 at a coupling 112a, as shown in figure 2. The coupling 112a may engage or interlock with a corresponding coupling 112b located on the handle portion 120 (see figure 3). This may allow different sized and/or shaped mounting portions 110 to be used interchangeably, e.g. to fit users with fingers 550 of different thicknesses, or to fit either the left or right hand as shown in figure 3 and discussed further below.

The handle portion 120 is a generally elongate body with a length and width sized and/or dimensioned such that, preferably, all four fingers 550 of a hand 500 are accommodated along the length of the handle portion side(s) 124 and can wrap around a substantial portion of the handle portion side(s) 124. In the example shown, the handle portion 120 is substantially cylindrical, but it may take on other forms. For example, alternatively the handle portion 120 may be substantially square or triangular in cross-section, and/or may be ergonomically shaped, e.g. to conform to the shape of the hand 500 and/or fingers 550 when in the closed position (not shown). The diameter or width of the handle portion 120 may be in the range of substantially 2 to 4 cm. The length of the handle portion 120 may be in the range of substantially 6 to 16 cm.

The handle portion 120 comprises a non-conductive outer skin 126, as indicated in figure 2. The outer skin 126 is the interface layer that the user's finger 550, thumb or hand 500 touches. The non-conductive material of the outer skin 126 may be substantially soft or rigid.

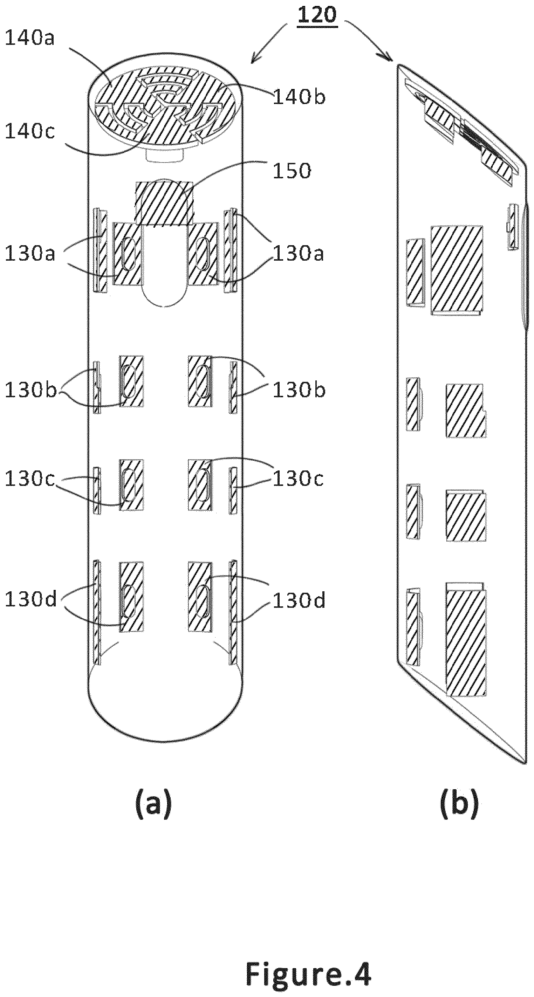

The handle portion 120 further comprises a plurality of touch sensing electrodes or electrode portions 130a-130d, 140a-140c, 150 (see figure 4). The touch sensing electrodes/portions 130a-130d, 140a-140c, 150 are formed of or comprise a non-metallic conductive material, such as conductive plastics (e.g. conductive acrylonitrile butadiene styrene (ABS), conductive ethylene vinyl acetate (EVA), or conductive polyurethane (PU)). The touch sensing electrodes 130a-130d, 140a-140c, 150 are located beneath the outer skin 128 and couple capacitively to a nearby conductive object, such as an operator's finger 550, thumb 560 or hand 500. Each touch sensing electrode/electrode portion 130a-130d, 140a-140c, 150 is configured to provide one or more electrical signals in response to a change in capacitance between the respective sensing electrode/electrode portion 130a-130d, 140a-140c, 150 and a portion of the user's finger, thumb 560 or hand 500 being near to or in contact with the outer skin 126 above the respective touch sensing electrode 130a-130d, 140c-140d, 150.

The outer skin 126 provides a non-conductive spacer layer to set up the capacitance between the finger(s) 550, thumb 560 or hand 500 and the touch sensing electrode/electrode portion130a-130d, 140c-140d, 150. The outer skin 126 may be formed and/or provided on or over the touch sensing electrode 130a-130d, 140c-140d, 150. The touch sensing electrodes/electrode portions 130a-130d, 140c-140d, 150 may be embedded or formed at least partially within the outer skin 126. Alternatively or additionally, a separate layer of non-conductive material may be provided between touch sensing electrode/electrode portions 130a-130d, 140c-140d, 150 and the outer skin 126.

An example electrode arrangement is shown in figures 4a and 4b. Different touch sensing electrodes may provide different functions. The touch sensing electrodes /electrode portions 130a-130d are configured and/or arranged to sense one or more fingers 550 being near to or in contact with the outer skin 126 above the respective sensing electrodes 130a-130d. The finger sensing electrodes 130a-130d are spatially distributed around the handle portion 120, such that each finger sensing electrode 130a-130d is responsive to the capacitance between themselves and a different portion of a user's finger(s) 550. The finger sensing electrodes 130a-130d are further arranged around the handle portion 120 in groups or sets, with each set of finger sensing electrodes 130a-130d being provided for a different finger 550. In the example of figure 4a, electrodes 130a may form a first set of finger sensing electrodes for the index finger, electrodes 130b may form a second set of finger sensing electrodes for the middle finger, electrodes 130c may form a third set of finger sensing electrodes for the third finger, and electrodes 130d may form a fourth set of finger sensing electrodes for the fourth finger. Although four sets of finger sensing electrodes 130a-130d are shown, it will be appreciated that the device 100 may comprise one, two three or four sets, depending on the application of the device 100. Further, although each set in the embodiment of figure 4a has four electrodes, in other embodiments each set may have fewer electrodes or a greater number of electrodes.

The touch sensing electrodes 140a-140c are configured and arranged to sense an operator's thumb 560 being near to or in contact with the outer skin 126 above the respective thumb sensing electrodes 140a-140c. Thumb sensing electrodes 140a-140c comprise part of a thumb track pad 122a positioned at an end 122 of the handle portion 120, as shown in figures 1a, 1b and 2.

The device 100 may further comprise an input 170 and/or output 172 element disposed about the handle portion 120, such as a control input, power button, light emitting device, sound emitting device. The input element(s) 170 may comprise a touch sensing electrode 150 (see figure 4a) to sense an operator's finger 550, thumb 560 or hand 500 being near to or in contact with the outer skin 126 above the respective touch sensing electrode 150. The output element 172, e.g. a light emitting device, may be actuated in response to the electrical signal provided by the operator touching the input element 170.

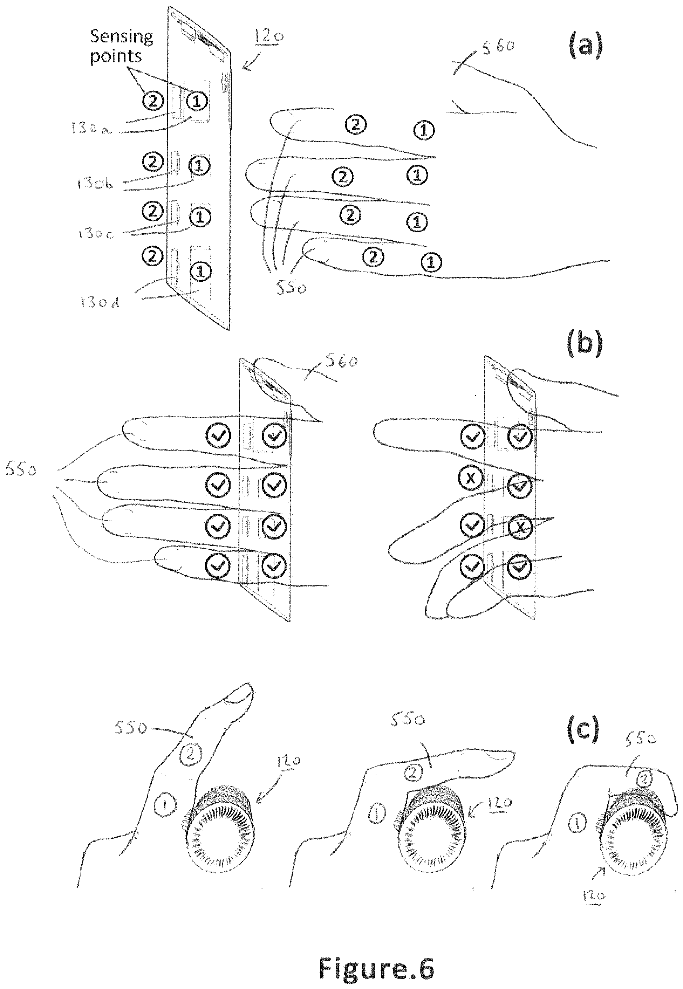

The device 100 further comprises a measurement module 300 configured to receive the or each electrical signal from the touch sensing electrodes 130a-130d, 140a-140c, 150. The measurement module 300 is configured to determine a position of the operator's finger 550, thumb 560 or hand 500 relative to one or more touch sensing electrodes 130a-130d, 140a-140c based on the or each electrical signal received (discussed further below with reference to figure 6). The measurement module 300 comprises a microcontroller unit for processing the electrical signals received from the electrodes and determining positions of the finger 550. The measurement module 300 may further comprise additional hardware, including a wireless communication unit (e.g. Bluetooth, Bluetooth low energy, or WiFi) for communicating with a remote computing device, and a power management unit for powering the measurement module 300. For example, the power management unit may be connectable to a battery, or the power management unit may comprise a re-chargeable battery. The measurement module 300 may further comprise an inertial measurement unit (IMU). The IMU may comprise an accelerometer, gyroscope and/or a magnetometer (e.g. the IMU may have 9 degrees of freedom).

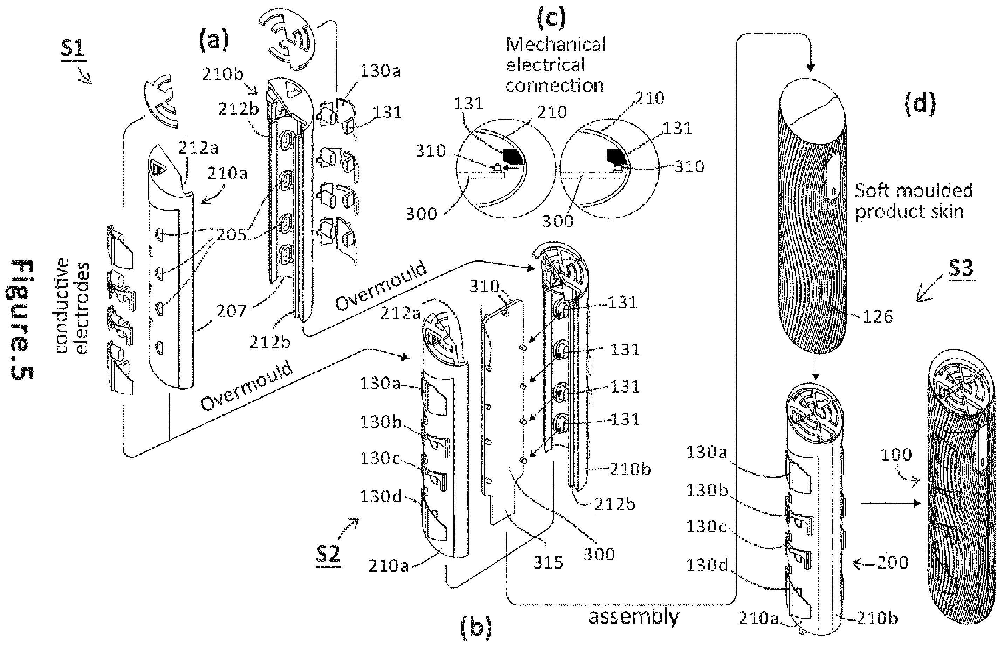

Each touch sensing electrode 130a-130d, 140a-140c, 150 is individually addressable by the measurement module 300. The measurement module 300 comprises one or more electrical connectors 310 configured to mechanically (and electrically) contact the touch sensing electrodes 130a-130d, 140a-140c, 150 (i.e. an electrical connection that does not require solder or other form of bonding agent). The measurement module 300 is mountable to a fixed position within the handle portion 120 in which the connectors 310 mechanically contact the touch sensing electrode 130a-130d, 140a-140c, 150. In other words, the measurement module 300 is configured to be simply "plugged" into the handle portion 120 (e.g. during assembly of the device 100). Additionally, the measurement module 300 may be unmounted or unplugged from the handle portion 120, if necessary. This direct connection arrangement greatly simplifies the manufacture and assembly or the device 100, as will be discussed in more detail with reference to figure 5.

The handle portion 120 may further comprise a substantially rigid hollow core 200 to support the touch sensing electrodes 130a-130d, 140a-140c, 150, the outer skin 126 and/or the overall shape/structure of the handle portion 120. The touch sensing electrodes 130a-130d, 140a-140c, 150 are be embedded or formed at least partially in or on the core 200, and the outer skin 126 may be formed or provided over the touch sensing electrodes 130a-130d, 140a-140c, 150 and the core 200. The core 200 is formed of or comprises a non-conductive material, e.g. to avoid shorting the touch sensing electrodes 130a-130d, 140a-140c, 150. The core 200 may comprise the coupling 112b used to connect the mounting portion 110 to the handle portion 120.

To simplify manufacture of the device 100, the core 200 may be formed from two or more shell portions 210a, 210b that join together, e.g. during assembly (discussed further with reference to figures 5a-5c). Each shell portion 210a, 210b may comprise one or more interlocking members 212 for securing the shell portions 210a, 210b together. The interlocking member(s) 212 on each shell portion may be configured to overlap or otherwise fit together when the two shell portions are brought together. For example, the interlocking member(s) 212 may be or comprise one or more male and female type connectors, projections, recesses and/or clips.

In an alternative embodiment, the outer skin 126 may be or comprise a substantially rigid non-conductive material which serves as an interface layer, and supports both the touch sensing electrodes 130a-130d, 140a-140c, 150 and the overall shape/structure of the handle portion 120 (i.e. the outer skin may be the core 200).

The measurement module 300 is mountable within the cavity of the core to the fixed position. As such, the connector(s) 310 contact the touch sensing electrodes 130a-130d, 140a-140c, 150 directly from the cavity side of the core 200. To facilitate this, each touch sensing electrodes 130a-130d, 140a-140c, 150 is formed over, in, and/or extends through an opening 205 in the wall 207 of the core 200, such that at least a contacting portion 131 of a respective electrode 130a, 130b, 130c, 130d is exposed and accessible from the cavity side by a connector 310 (see figure 5a). For example, the contacting portion 131 may extend through an opening 205 into the cavity as shown in figure 5c. Alternatively, the contacting portion 131 may be or comprise an interior surface of the touch sensing electrode 130a-130d, 140a-140c, 150 that extends over an opening 205, or the contacting portion 131 may extend at least partially into the opening 205. In these latter two examples, each connector 310 may extend at least partially into the opening 205 to contact the respective touch sensing electrode 130a-130d, 140a-140c, 150.

The or each connector 310 comprises a substantially rigid mating portion that bears against the contacting portion 131 when the measurement module 300 is mounted in the fixed portion. The mating portion may additionally be configured to at least partially deform or penetrate the exposed contacting portion 131 to make an electrical contact with it. The mating portion may be or comprise one or more metal projections, a pin, a castellated pad, a clip pin, or any other form of metal connector that allows a secure mechanical connection to the electrode (see figures 5b and 5c). When the measurement module 300 is in the fixed position, the mating portion may be biased towards the contacting portion 131 of the electrode, and/or vice versa. For example, the pin or projection may be spring loaded. Additionally or alternatively, the non-metallic conductive material of the contacting portion 310 may be substantially resilient and apply a reaction force against the mating portion in response to deformation (e.g. compression or bending) by the mating portion.

The touch sensing electrodes 130a-130d, 140c-140d, 150, the outer skin 126 and/or the core 200 are moulded components formed of or comprising thermo-formable materials. This allows the touch sensing electrode 130a-130d, 140c-140d, 150, the outer skin 126 and/or the core 200 to be formed by a moulding process, such as injection moulding, heat pressing or any other thermo-forming process. The touch sensing electrode 130a-130d, 140c-140d, 150, the outer skin 126 and/or the core 200 can be moulded separately and then post-assembled together. Alternatively, the core 200 and the touch sensing electrode 130a-130d, 140c-140d, 150 (and optionally the outer skin 126) may be formed by an over-moulding process (i.e. moulded using the same tool set).

The material used for the outer skin 126 and the core 200 may be the same or different. In an embodiment, the outer skin 126 is substantially soft and formed of non-conductive silicon rubber, EVA or polyurethane (PU). The skin may also comprise an exterior coating or layer, such as fabric or synthetic leather. Suitable materials for the casing 200 include but are not limited to non-conductive plastics, such as PU, ABS plastic, or poly carbonate (PC).

The touch sensing electrode 130a-130d, 140c-140d, 150 are formed simultaneously using a single mould to have pre-defined 3D electrode shapes, spacings and arrangements with the thermo-forming processes described above.

In the embodiment of figures 4 and 5, each touch sensing electrode 130a-130d, 140a-140c, 150 is a separate moulded electrically isolated electrode, and is connectable to a separate connector 310. In an alternative embodiment (not shown), two or more touch sensing electrodes, e.g. in a finger sensing set 130a-130d or a thumb trackpad set 140a-140c, may be physically and/or electrically connected to each other. In this case, each connected electrode 130a-130d, 140a-140c may be an electrode portion (e.g. a portion of a unitary piece of the non-metallic conductive material) which is similarly connectable to a separate connector 310 at a contacting portion 131 to provide a different electrical signal. Connected electrodes portions 130a-130d, 140a-140c may be thermo-formed as a unitary piece of non-metallic conductive material, such that only one set of mould tooling is needed. Connected electrode portions 130a-130d, 140a-140c may simply manufacture of the sensor device 100, e.g. by reducing the number of parts that need assembling.

The outer skin 126 may be formed with a textured or profiled exterior surface, e.g. to increase grip (see figures 1a and 1b). Additionally, the outer skin 126 may be formed with one or more raised or hill structures 128 disposed at a back side of the handle portion 120 facing the mounting portion 110, as shown in figure 2. Where present, the hill structures 128 are configured to locate the fingers 550 on the handle portion 120 at a predetermined position along the length of the handle portion 120 and/or with a predetermined separation. For example, a hill structure 126 may be arranged to locate and separate the index finger and middle finger. Additional hill structures 128 may be used to locate and separate the middle finger and the third finger, and/or the third finger and fourth finger, as shown.

The touch sensing electrodes (or electrode portions) 130a-130d, 140a-140c, 150 can be formed or moulded into almost any arbitrary size, shape or three-dimensional (3D) form by the nature of the moulding process. For example, the touch sensing electrodes 130a-130d, 140a-140c, 150 may conform the exterior shape of the handle portion 120, core 200 and/or the interior/exterior surface of the outer skin 126 regardless of complexity. This significantly increases the design freedom for the electrode shape, arrangement and the device 100 itself.

The touch sensing electrode portion(s) have 3D volumes and can cover larger areas enabling them to be more sensitive to small capacitance changes and produce larger signal changes compared to the typically smaller metal electrode counterparts.

For example, in a simplistic parallel plate capacitor model, the capacitance C between a touch sensing electrode 130a-130d, 140a-140c, 150 and a portion of the finger 550 near to/over the touch sensing electrode 130a-130d, 140a-140c, 150 is proportional to the overlap between the finger portion's contact area A_{F} (i.e. the surface area of the finger 550 contacting the outer skin 126) and the electrode's sensing area A_{E}, and is inversely proportional to the electrode-finger separation d (e.g. the spacer layer thickness), according to C α A_{E}A_{F}/(d*(A_{E}+A_{F})). For sensor devices with relatively small electrodes compared to the width of a finger (such as those using conventional metal electrodes), A_{E} is typically much smaller than A_{F} and the resulting capacitance and electrical signal produced for a given separation d will be small compared to that produced using larger electrodes that are comparable to the width of the finger 550, such as the moulded electrodes 130a-130d, 140a-140c, 150. The approach in conventional technologies is to compensate for small A_{E} by reducing the thickness d of the spacer layer (i.e. outer skin). However, this approach places technical limitations on the form and dielectric properties of the spacer layer material, and the construction of a sensor device itself. Advantageously, the moulded non-metallic touch sensing electrodes 130a-130d, 140a-140c, 150 can be comparable to or even larger than a typical (maximum) finger contact area A_{F}, relaxing the technical requirements of the outer skin 126 (e.g. thickness and form) compared to conventional sensor devices, which in turn simplifies manufacture and assembly of the device (discussed further below).

In addition, the electrical signals provided by each moulded non-metallic touch sensing electrode 130a-130d, 140a-140c, 150 and its responsivity can be tailored through its size and shape. For example, the functional form of the signal change between the minimum and maximum signal values can be tailored to be substantially smooth and gradual. This allows the touch sensing electrode portion(s) to sense/resolve a wider range of finger/hand movements.

For example, as the finger 500 position changes between an open and closed position (i.e. when the user grips/un-grips the handle portion 120), the finger contact area A_{F} will change according to the pressure applied to the outer skin 126 by the operator. For sensor devices using conventional metal electrodes where the active sensing area A_{E} is relatively small compared to the width of a finger, the overlap area and corresponding electrical signal will change rapidly from a minimum to a maximum at the point where the finger 550 moves into contact with the spacer layer, or vice versa (since the finger contact area A_{F} instantly/rapidly fills the sensing area A_{E}). By contrast, because the moulded non-metallic touch sensing electrodes 130a-130d, 140a-140c, 150 can be comparable to or larger than the width of the finger 550, the transition from a minimum to a maximum electrical signal as the finger 550 moves between an open and closed position can be relatively smooth and controlled. This allows the device 100 to determine a wider range of finger positions and/or movements (discussed in more detail below with reference to figure 6).

Figure 6 illustrates the operation of the device 100. In use, the device 100 is mounted to an operator's hand 500 at an operating position, as shown in figures 1a and 1b. The electrode arrangement of the device 100 ensures that each finger 550 can be correlated with one or more electrical signals, each electrical signal mapping to a different portion of the finger 550. In other words, each finger sensing electrodes 130a-130d provides an electrical signal associated with a specific portion of the finger 550. Preferably, the device 100 is mounted to the hand 500 in an operating position such that separate finger sensing electrodes 130a-130d correlates with the position of the proximal phalanges 1 and intermediate phalanges 2 of a finger 550, as indicated in figure 6a. The phalanges 1, 2 comprise the pads of the finger 550 that typically contact the outer skin 126 when in the closed position. As such, each set of finger sensing electrodes 130a-130d may comprise at least one first electrode arranged to detect the proximity of the proximal phalange 1 and at least one second electrode arranged to detect the proximity of the intermediate phalange 2. Each finger sensing electrodes 130a-130d may comprise a third electrode arranged to detect the proximity of the distal phalange 3, but this is not essential to determine the position of the finger 550, as discussed below.

When an operator's finger 550, thumb 560 or hand 500 moves close to, touches, or move across the surface of the outer skin 126, an electrical signal is generated by one or more touch sensing electrodes (or electrode portions) 130a-130d, 140a-140c, 150 and is received by the measurement module 300 in near real time. The measurement module 300 may be configured to scan through each connector 310 connected to the touch sensing electrodes 130a-130d, 140a-140c, 150 sequentially (i.e. one by one) to measure each electrical signal separately. The measurement module 300 may comprise a multiplexer function. The scan frequency may be sufficiently high compared to a typical movement speed of a finger 550, thumb 560 or hand 500 to minimise any measurement lag, such that an operator perceives the measurement/detection to be in real-time. For example, the scan rate may be in the range 100-200 Hz. The scan rate may be slower or faster depending on the application. In this way, only one sensing point (i.e. a contacting portion 131) is actively connected to the measurement module 300 at a time. For example, while an electrical signal is being measured from one sensing point, other (non-active) sensing points may be disconnected from the measurement module 300. This may be achieved via one or more switching circuits controlled by the measurement module 300 or software. The switching circuits may be internal to the measurement module 300 (e.g. part of the microcontroller unit) or in an external intermediate unit connected to the measurement module 300 and controlled by software. Alternatively, the measurement module 300 may be configured to read/measure the electrical signals received at each connector 310 simultaneously.

Advantageously, scanning through the connectors 310 one by one ensures that no short circuits are formed between any given pair of connectors 310 (e.g. through a two or more connected electrode portions). As such, the scanning method allows the touch sensing electrodes 130a-130d, 140a-140c, 150 to be connected and therefore be moulded using one mould. In this case, the touch sensing electrode portions 130a, 130b, 130c, 130d are connected via thin connecting structures made out of the same non-metallic conductive material during the same moulding process, such that the resistance between two close-by electrode portions is sufficiently high, such that the electrical signal(s) received by a particular connector 310 is predominately affected by the electrode portion it is connected to. Through this, the measurement method allows multi-finger sensing with a unitary electrode.

Similarly, although each touch sensing electrode or electrode portion 130a-130d, 140a-140c, 150in figures 4 and 5 is shown as being connected to a single connector 310, in other examples, each touch sensing electrode or electrode portion 130a-130d, 140a-140c, 150 may be connected to two or more connectors 310 at different sensing points/contacting portions 131, each sensing point/contacting portion 131 providing a separate electrical signal to the measurement module 300 from a strategic point on the respective electrode/electrode portion.

Each finger sensing electrode (or electrode portion) 130a-130d provides an electrical signal between a maximum value and a minimum value representing how open or closed the finger 550/hand 500 is. A minimum value may be provided when the finger 550 is completely flat open, as shown in figure 1a, such that the finger phalanges 1, 2, 3 do not contact the outer skin 126 over the respective finger sensing electrodes (or electrode portions) 130a-130d. A maximum value may be provided when the finger 550 is closed or curled/wrapped around the handle portion 120, such that the finger phalanges 1, 2, 3 contact the outer skin 126 over the respective finger sensing electrodes (or electrode portions) 130a-130d. As discussed earlier, the moulded finger sensing electrodes (or electrode portions) 130a-130d may be shaped and/or sized such that at least one dimension of the sensing area A_{E} is comparable to the width of a finger 500, to make the change from minimum to maximum valve large and/or smooth. Each finger sensing electrodes (or electrode portions) 130a-130d is therefore capable of providing a range of intermediate signal values while the respective finger portion is in contact with the outer skin 126 above the respective electrode, with each intermediate value representing a different position or pose of the finger 550.

The operating position is preferably one where the device 10 is mounted between the first and second knuckles (between the MCP joint and the PIP joint) of the fingers 550 or on the proximal phalanges, as shown in figures 1a and 1b. As such, the proximal phalange 1 is typically in contact with the outer skin 126 above the first electrode for the whole range of movements between the open and closed positions and provides a corresponding high/non-zero value signal. This first electrode signal may be used to compare to each of the other signals in the electrode set to improve the robustness of the finger position measurement and avoid miss-touches. For example, because the first electrodes map to the proximal phalanges close to the knuckle, it is difficult to activate it with the wrong finger. The signal valve/level from the first electrode can then be used as a filter for the second electrode, and third electrode and so on, in a differential-type measurement to discriminate between genuine touches and miss-touches.

Using this technique, the device 100 can determine lateral rotation (spreading) of the finger(s) 550. This is illustrated in figure 6b which shows the natural alignment of fingers 550 with the device 100 (on the left) and the lateral movement of fingers (on the right) which may be determined. In the example shown in figure 6b (right), the second electrode of the third finger set 130c is triggered without the first electrode of that set being triggered (or the second electrode has a much higher value than the first electrode of the third finger set 130c), indicating that the second (middle) finger's lateral movement has activated the third finger's second electrode. As described above, the finger sensing electrodes (or electrode portions) 130a-130d are formed to have large enough sensing areas, such that even when the operator's fingers 550 are not perfectly aligned to the electrode positions, a clear signal change is still provided that indicates touch and/or movement from which the finger position can be determined. The electrical signals can be interpreted as forming a 'heat map' over the handle portion 120 indicating both the contact/touch areas as well as pressure of the fingers 550. Machine learning methods may be employed to translate the signal 'heat map' to gestures/finger positions.

In addition to detecting finger lateral movement, the use of signals from pairs of electrodes in a set enables estimation of the position and/or pose of the proximal 1, intermediate 2 and distal 3 phalanges separately. The first electrode maps to the rotation of the first knuckle (MCP joint) which determines the position of the proximal phalange 1. The rotations of the second knuckle (PIP joint) and the third knuckle (DIP joint) are linked, e.g. it is typically not possible to bend the third knuckle without bending the second knuckle, but it is possible to bend the second knuckle without bending the third knuckle (e.g., see figure 6c). As such, it is possible to infer or derive from the signals received from the first to third electrodes in a set the rotation of the first knuckle and position/pose of the proximal phalange 1, and then extrapolate the rotation of the second and third knuckles. The pose or position of the intermediate phalange 2 (and thus also the distal phalange 3) can then be estimated when the intermediate phalange 2 is not in contact with the outer skin 126 (e.g. see left part of figure 6c).

The finger or hand positons determined by the measurement module 300 may be transmitted to a computing device via the wireless communication unit, for example to display and/or animate the hand 500 or fingers 550 and/or to control one or more functions of the computing device based on the finger positions.

An alternative approach to determining the position of the finger 550/hand 500 involves calibrating the device 100 at two positions representing a completely open position and a closed positon (at the two extremes of possible movement). Intermediate positions may be calibrated as well. This may comprise storing a set of signal values for each finger position. In use, the measurement signal values can be compared to the stored values to derive a finger position. Intermediate positions (i.e. in between the calibrated positioned) may then be derived by interpolating between the calibration points.

The calibration values used to drive the interpolation can be calculated from a combination of the differential two-point sensing described above (filtering for miss-touches) multiplied by a weighting factor in the range of 0 to 1. It will be appreciated that numerous algorithms are possible, but a representative one can be specified mathematically as: $f \geq s \to \left(fα+βs\right)$ $f \leq s \to \left(fα\right)$ where *f* and s are the calibrated values for the first and second electrodes, and α and β are weighting factors for f and s respectively that sum to 1. Supporting this style of interpolation rather than encoding the finger positions directly means that an interface can be established between the device 100 and computer programs that use this for animation.

For both of the above methods, to compensate for the range of different hand sizes and conditions that a typical device 100 may encounter, the measurement module 300 may be configured to 'auto-calibrate' the device 100 by making an estimate of the signal values for each electrode that correspond to the 'closed' and 'open' hand positions (see above) at the extremes of the range of possible motion, and then adjusting the estimate of these values in response to changes in the measured signal values.

Machine learning methods may also be employed to improve the sensing robustness and customisation of the device 100 which allows the device 100 to become better for the individual user over time. Such methods translate data sets of signal values into position and gesture estimations. Machine learning models are trained on data sets with labelled inputs and expected position outputs (supervised learning), providing models which can estimate position. These predicted positions then get taken to train a second model using these and expected gesture outputs (again, supervised learning) to produce models which can classify gestures. This two-step process decouples the gesture recognition from the hardware, and makes it more practical to industrial uses.

Advantageously, the device 100 may be used for either the left hand or the right hand 500 by exchanging the mounting portion 110 for a left or right handed mounting portion 110 (see figure 3) and using the same handle portion 120. For this purpose, the electrode arrangement in the handle portion 120 is substantially symmetrically. The measurement module 300 may be configured to switch between a left hand mode and a right hand mode to re-configure how the electrical signals received at the connectors 310 are mapped to the position of the finger 550 or hand 500. Depending on the arrangement of electrodes and which hand the operator is using, some finger sensing electrodes or electrode portions 130a-130d may be located beneath the palm of the hand 500. Such electrodes can remain active and be used to determine a pressure of grip and/or which hand the operator is using, e.g. from the characteristic left hand or right hand heat map determined by the measurement module 300.

Alternatively or additionally, the handle portion 120 may further comprises a switching mechanism (not shown) configured to provide a control signal to the measurement module 300 to switch the measurement module 300 between the left hand mode and the right hand mode. The measurement module 300 is then configured to determine a position of a left hand finger based on the or each electrical signal and the control signal when in the left hand mode, and to determine a position of a right hand finger based on the or each electrical signal and the control signal when in the right hand mode, as described above.

The switching mechanism may be or comprise one of the further inputs 170. The switching mechanism may be or comprise a switch, button and/or sensor disposed on or in the handle portion 120. The switching mechanism may be actuated manually by the operator, or upon connection of the mounting portion 110 to the handle portion 120. For example, the switching mechanism may be incorporated in or part of the coupling 112b.

The use of thermo-formable non-metallic materials offers a unique manufacture and assembly solution for the device 100. In particular, the measurement module 300 can directly (mechanically) connect to the electrodes 130a, 130b, 130c, 130d upon mounting it within the handle portion 120, to form a complete device 100 without using any further wiring or soldering.

A general method of manufacturing the device 100 according to the invention comprises two steps. In step 1, the handle portion 120 is at least partially formed and/or assembled. This comprises moulding the touch sensing electrodes 130a-130d, 140a-140c, 150 or one or more unitary sensing electrodes with electrode portions 130a-130d, 140a-140c, 150 from a non-metallic conductive material and providing a moulded non-conductive material as a core 200 to mount/support each electrode or electrode portion 130a-130d, 140a-140c, 150.

In step 2, a measurement module 300 is provided and mounted within the handle portion 120 to connect to the electrodes (or portions) 130a-130d, 140a-140c, 150. The measurement module 300 can be mounted generally in two different ways. In one embodiment, mounting the measurement module 300 comprises moving or inserting the measurement module 300 into an assembled handle portion 120 (not shown). In another embodiment, the handle portion120 is assembled around the mounting module 300 (described in more detail below with reference to figure 5).

Where the core 200 is not provided on or over the electrodes (or portions) 130a-130d, 140a-140c, 150, a further a further non-conductive moulded material is provided over or on each electrode (or portion) 130a-130d, 140a-140c, 150 as an outer skin (before or after mounting the measurement module 300). This can be an additional over-moulding step or an assembling step where the outer skin is moulded independently. Sequences of the steps are interchangeable.

An example method of manufacturing the device 100 is illustrated in figures 5a-5d, in which the handle portion120 is assembled around the mounting module 300. In step S1 (see figure 5a), the two shell portions 210a, 210b of the hollow core 200 are moulded from a substantially rigid non-conductive material. The electrodes (or portions) 130a-130d, 140a-140c, 150 are then moulded on or over each shell portion 210a, 210b of the core 200 from a non-metallic conductive material (this may be an over-moulding process). In step S2 (see figure 5b), a measurement unit 300 comprising a plurality of connectors 310 is provided and mounted within the cavity of the core 200 to contact the contacting portions 131 of the electrodes (or portions) 130a-130d, 140a-140c, 150. This is achieved by joining or assembling the two shell portions 210a, 210b around the measurement module 300 in the direction generally indicated by the arrows. Assembling the two shell portions 210a, 210b as shown may cause the interlocking members 212 on each shell portion 210a, 210b to engage each other and lock the shell portions 210a, 210b together. As the shell portions 210a, 210b are joined/assembled around the measurement module 300, the connectors 310 engage and mechanically contact the contacting portions 131 of the electrodes (or portions) 130a-130d, 140a-140c, 150, as shown in figure 5c. The measurement module 300 may be held in place during this step (e.g. via a tab 315 at one end of the measurement module 300).

Each shell portion 210a, 210b may optionally comprise one or more guiding structures (such as recesses, channels or posts) to guide the measurement module 300 into the correction fixed position as the shell portions 210a, 210b are joined. This may help to ensure the connectors 310 properly contact each electrode (or portion) 130a-130d, 140a-140c, 150.

In step S3 (see figure 5d), the outer skin 126 is moulded from a non-conductive malleable material and is provided on or over the core 200/electrode assembly to complete the device 100. This may comprise a further over-moulding step. Alternatively, this may comprise sliding or fitting the moulded outer skin 126 over the core 200/electrode assembly.

Alternatively, the measurement module 300 can be mounted into the core 200/electrode assembly (not shown). For example, the step S1 may further comprise joining or assembling the two shell portions 210a, 210b to form the casing 200/electrode assembly (before or after moulding the electrodes (or portions) 130a-130d, 140a-140c, 150 on or over each shell portion 210a, 210b) and step S2 may comprise moving or inserting the measurement module 300 into the cavity formed by the core 200 to contact the contacting portions 131 of the electrodes 130a, 130b, 130c, 130d. In this case, the core 200 need not be formed from shell portions 210a, 210b and step S1 may instead comprise moulding the unitary hollow core 200.

In both methods, the electrodes (or portions) 130a-130d, 140a-140c, 150, the core 200 and/or the outer skin 126 may be injection moulded. Further, instead of using an over-moulding process, the electrodes (or portions) 130a-130d, 140a-140c, 150 and the core 200 (and shell portions 212a, 210b) may be moulded separately and assembled together (e.g. before mounting the measurement module 300).

Optionally, where the outer skin 126 is substantially rigid a separate core 200 may not be required, since it may serve the purpose of supporting and holding the electrodes (or portions) 130a-130d, 140a-140c, 150 in place. In this case, step S1 may comprise moulding the outer skin 126 and moulding the electrodes (or portions) 130a-130d, 140a-140c, 150 onto an interior surface of the outer skin 126 (or moulding the electrodes (or portions) 130a-130d, 140a-140c, 150 and moulding the outer skin 126 on or over the electrodes 130a, 130b, 130c, 130d) to form an outer skin 126/electrode assembly. The outer skin 126 may be formed from two shell portions, similarly to the core 200.

Due to the mouldable materials used to the form the touch sensing electrodes (or portions) 130a-130d, 140a-140c, 150, core 200 and/or outer skin 126, the device 100 is substantially lightweight compared to devices using conventional sensor technologies and metal electrode materials. In an embodiment, the device 100 may have a total weight of 200 g or less, or 150 g or less.

Furthermore, the use of moulded components and mechanical interconnections greatly simplifies the manufacture and assembly of the device 100. This, together with the relatively inexpensive materials, means the cost of manufacturing the device 100 is also substantially less than sensor devices based on conventional materials and sensing technologies (e.g. using metal electrodes, wires and/or flexible circuits).

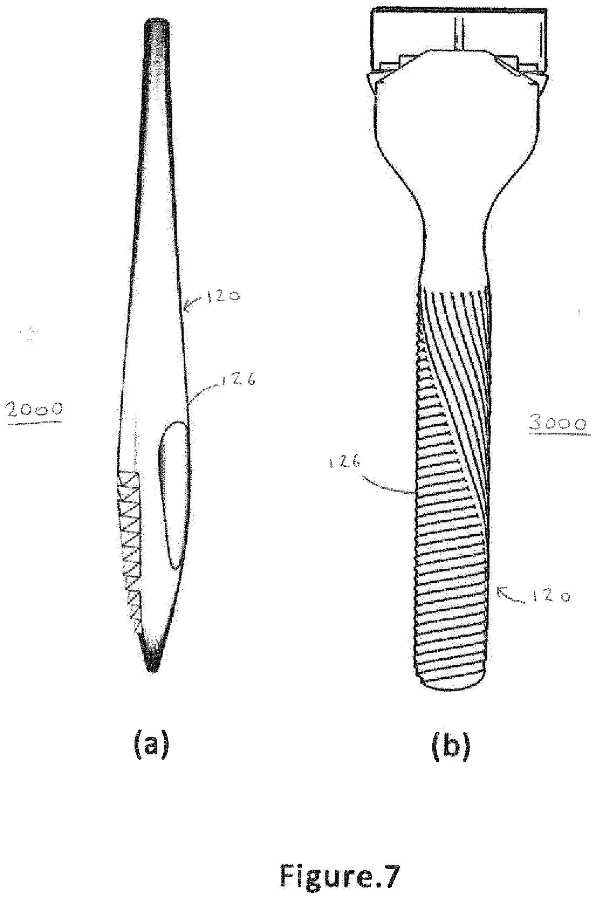

This method of manufacturing a hand-mountable sensor device can also be applied to other products with a similar format that are hand-held, such as a sensor-embedded stylus (see figure 7a), a sensor-embedded smart razor (see figure 7b), a smart toothbrush (not shown), or a sensor embedded automotive door handle (not shown). These products do not traditionally have finger/thumb or hand position detection functionality, however, could benefit from having additional sensing functions to complete tasks such as intuitive gestural control, force threshold monitoring, consumer data collection etc. The invention disclosed makes it possible to incorporate finger/hand position sensing on these devices with limited space, weight and sculptural 3D profiles.

## Claims

1. A sensor device (100) for determining a position of an operator's finger/hand, comprising:
a handle portion (120) comprising one or more touch sensing electrode portions (130a-130d, 140a-140c, 150), each touch sensing electrode portion configured to provide an electrical signal in response to the operator's finger/hand being on or near the one or more touch sensing electrode portions, and
a measurement module (300) comprising one or more electrical connectors (310) configured to mechanically contact the or each respective touch sensing electrode portion and receive the or each electrical signal from the touch sensing electrode portion(s), wherein the measurement module is configured to determine a position of the operator's finger/hand relative to one or more of the touch sensing electrode portions based on the or each electrical signal received,
wherein the or each touch sensing electrode portion is or comprises a thermo-formable non-metallic conductive material.

2. The sensor device of claim 1, wherein the handle portion (120) comprises a first non-conductive material (126) at least provided on or over the or each touch sensing electrode portion (130a-130d, 140a-140c, 150).

3. The sensor device of claim 2, wherein the first non-conductive material (126) is configured to provide a hand and/or finger grip and, optionally or preferably, has a three dimensionally profiled exterior surface.

4. The sensor device of claim 3, wherein the or each sensing electrode portion (130a-130d, 140a-140c, 150) has a sensing surface configured, for example formed with a three dimensional profile, to conform to the exterior surface of the first non-conductive material (126).

5. The sensor device of any of claims 2 to 4, wherein the first non-conductive material (126) is substantially rigid, pliable and/or deformable.

6. The sensor device of any preceding claim, wherein the one or more touch sensing electrode portions (130a-130d, 140a-140c, 150) comprises a plurality of touch sensing electrode portions (130a-130d, 140a-140c, 150) spatially distributed around the handle portion (120), wherein each touch sensing electrode portion is configured to provide the electrical signal in response to touch by an operator, such as touch by different portions of a digit or different digits.

7. The sensor device of any preceding claim, wherein the or each electrical signal is provided in response to a change in capacitance between the respective touch sensing electrode portion (130a-130d, 140a-140c, 150) and the operator's finger/hand.

8. The sensor device of any preceding claim, further comprising a hand mounting portion (110) connected or connectable to the handle portion (120) and configured to mount the handle portion to said operator's finger/hand.

9. The sensor device of any preceding claim, further comprising a switching mechanism (170) configured to provide a control signal to the measurement module (300) to switch the measurement module between a left hand mode and a right hand mode.

10. The sensor device of claim 9, wherein the measurement module (300) is configured to determine a position of a left hand finger based on the or each electrical signal and the control signal when in the left hand mode, and to determine a position of a right hand finger based on the or each electrical signal and the control signal when in the right hand mode.

11. The sensor device of claim 9 or claim 10, wherein the switching mechanism is a switch, button or sensor disposed on or in the handle portion.

12. The sensor device of any of claims 9 to 11, wherein the switching mechanism is actuated upon connection of the hand mounting portion (110) to the handle portion (120).

## Patentansprüche

1. Sensorvorrichtung (100) zum Bestimmen einer Position eines Fingers/einer Hand eines Bedieners, umfassend:
einen Griffabschnitt (120), umfassend einen oder mehrere Berührungserfassungselektrodenabschnitte (130a-130d, 140a-140c, 150), wobei jeder Berührungserfassungselektrodenabschnitt dazu konfiguriert ist, ein elektrisches Signal als Reaktion darauf bereitzustellen, dass sich der Finger/die Hand des Bedieners auf oder nahe dem einen oder den mehreren Berührungserfassungselektrodenabschnitten befindet, und
ein Messmodul (300), umfassend einen oder mehrere elektrische Verbinder (310), die dazu konfiguriert sind, den oder jeden jeweiligen Berührungserfassungselektrodenabschnitt mechanisch zu kontaktieren und das oder jedes elektrische Signal von dem/den Berührungserfassungselektrodenabschnitt(en) zu empfangen, wobei das Messmodul dazu konfiguriert ist, eine Position des Fingers/der Hand des Bedieners in Bezug auf einen oder mehrere der Berührungserfassungselektrodenabschnitte basierend auf dem oder jedem empfangenen elektrischen Signal zu bestimmen,
wobei der oder jeder Berührungserfassungselektrodenabschnitt ein thermoformbares nichtmetallisches leitfähiges Material ist oder umfasst.

2. Sensorvorrichtung nach Anspruch 1, wobei der Griffabschnitt (120) ein erstes nicht leitfähiges Material (126) umfasst, das mindestens auf oder über dem oder jedem Berührungserfassungselektrodenabschnitt (130a-130d, 140a-140c, 150) bereitgestellt ist.

3. Sensorvorrichtung nach Anspruch 2, wobei das erste nicht leitfähige Material (126) dazu konfiguriert ist, einen Hand- und/oder Fingergriff bereitzustellen, und optional oder bevorzugt eine dreidimensional profilierte Außenfläche aufweist.

4. Sensorvorrichtung nach Anspruch 3, wobei der oder jeder Erfassungselektrodenabschnitt (130a-130d, 140a-140c, 150) eine Erfassungsoberfläche aufweist, die dazu konfiguriert ist, zum Beispiel mit einem dreidimensionalen Profil gebildet, der Außenfläche des ersten nicht leitfähigen Materials (126) zu entsprechen.

5. Sensorvorrichtung nach einem der Ansprüche 2 bis 4, wobei das erste nicht leitfähige Material (126) im Wesentlichen starr, biegsam und/oder verformbar ist.

6. Sensorvorrichtung nach einem der vorhergehenden Ansprüche, wobei der eine oder die mehreren Berührungserfassungselektrodenabschnitte (130a-130d, 140a-140c, 150) eine Vielzahl von Berührungserfassungselektrodenabschnitten (130a-130d, 140a-140c, 151), die räumlich um den Griffabschnitt (120) verteilt ist, umfassen, wobei jeder Berührungserfassungselektrodenabschnitt dazu konfiguriert ist, das elektrische Signal als Reaktion auf eine Berührung durch einen Bediener bereitzustellen, wie etwa eine Berührung durch unterschiedliche Abschnitte eines Fingerglieds oder unterschiedliche Fingerglieder.

7. Sensorvorrichtung nach einem der vorhergehenden Ansprüche, wobei das oder jedes elektrische Signal als Reaktion auf eine Kapazitätsänderung zwischen dem jeweiligen Berührungserfassungselektrodenabschnitt (130a-130d, 140a-140c, 150) und dem Finger/der Hand des Bedieners bereitgestellt ist.

8. Sensorvorrichtung nach einem der vorhergehenden Ansprüche, ferner umfassend einen Handmontageabschnitt (110), der mit dem Griffabschnitt (120) verbunden oder verbindbar und dazu konfiguriert ist, den Griffabschnitt an dem Finger/der Hand des Bedieners zu montieren.

9. Sensorvorrichtung nach einem der vorhergehenden Ansprüche, ferner umfassend einen Schaltmechanismus (170), der dazu konfiguriert ist, ein Steuersignal an das Messmodul (300) bereitzustellen, um das Messmodul zwischen einem linken Handmodus und einem rechten Handmodus umzuschalten.

10. Sensorvorrichtung nach Anspruch 9, wobei das Messmodul (300) dazu konfiguriert ist, eine Position eines linken Handfingers basierend auf dem oder jedem elektrischen Signal und dem Steuersignal zu bestimmen, wenn es sich in dem linken Handmodus befindet, und eine Position eines rechten Handfingers basierend auf dem oder jedem elektrischen Signal und dem Steuersignal zu bestimmen, wenn es sich in dem rechten Handmodus befindet.

11. Sensorvorrichtung nach Anspruch 9 oder Anspruch 10, wobei der Schaltmechanismus ein Schalter, ein Knopf oder ein Sensor ist, der auf oder in dem Griffabschnitt angeordnet ist.

12. Sensorvorrichtung nach einem der Ansprüche 9 bis 11, wobei der Schaltmechanismus bei einer Verbindung des Handmontageabschnitts (110) mit dem Griffabschnitt (120) betätigt wird.

## Revendications

1. Dispositif de capteur (100) pour la détermination d'une position d'un doigt/d'une main d'un opérateur, comprenant :
une portion de poignée (120) comprenant une ou plusieurs portions d'électrode de détection tactile (130a-130d, 140a-140c, 150), chaque portion d'électrode de détection tactile étant configurée pour la fourniture d'un signal électrique en réponse à la présence du doigt/de la main de l'opérateur sur ou près de l'une ou plusieurs portions d'électrode de détection tactile, et
un module de mesure (300) comprenant un ou plusieurs connecteurs électriques (310) configurés pour le contact mécanique de l'une ou de chaque portion d'électrode de détection tactile respective et la réception de l'un ou de chaque signal électrique en provenance de l'une ou plusieurs portions d'électrode de détection tactile, dans lequel le module de mesure est configuré pour déterminer une position du doigt/de la main de l'opérateur par rapport à une ou plusieurs portions d'électrode de détection tactile sur la base du ou de chaque signal électrique reçu,
dans lequel l'une ou chaque portion d'électrode de détection tactile est un matériau conducteur non métallique thermoformable ou comprend celui-ci.

2. Dispositif de capteur selon la revendication 1, dans lequel la portion de poignée (120) comprend un premier matériau non conducteur (126) au moins prévu sur l'une ou de chaque portion d'électrode de détection tactile (130a-130d, 140a-140c, 150) ou au-dessus de celle-ci.

3. Dispositif de capteur selon la revendication 2, dans lequel le premier matériau non conducteur (126) est configuré pour la fourniture d'une prise pour main et/ou doigt et, éventuellement ou de préférence, a une surface extérieure profilée en trois dimensions.

4. Dispositif de capteur selon la revendication 3, dans lequel l'une ou chaque portion d'électrode de détection (130a-130d, 140a-140c, 150) a une surface de détection configurée, par exemple formée avec un profil en trois dimensions, pour se conformer à la surface extérieure du premier matériau non conducteur (126).

5. Dispositif de capteur selon l'une quelconque des revendications 2 à 4, dans lequel le premier matériau non conducteur (126) est sensiblement rigide, pliable et/ou déformable.

6. Dispositif de capteur selon l'une quelconque des revendications précédentes, dans lequel l'une ou plusieurs portions d'électrode de détection tactile (130a-130d, 140a-140c, 150) comprennent une pluralité de portions d'électrode de détection tactile (130a-130d, 140a-140c, 151) distribuées spatialement autour de la portion de poignée (120), dans lequel chaque portion d'électrode de détection tactile est configurée pour la fourniture du signal électrique en réponse à un toucher par un opérateur, tel qu'un toucher par différentes portions d'un doigt ou différents doigts.

7. Dispositif de capteur selon l'une quelconque des revendications précédentes, dans lequel l'un ou chaque signal électrique est fourni en réponse à un changement de capacité entre la portion d'électrode de détection tactile (130a-130d, 140a-140c, 150) respective et le doigt/la main de l'opérateur.

8. Dispositif de capteur selon l'une quelconque des revendications précédentes, comprenant en outre une portion de montage sur main (110) connectée ou connectable à la portion de poignée (120) et configurée pour le montage de la portion de poignée sur ledit doigt/ladite main de l'opérateur.

9. Dispositif de capteur selon l'une quelconque des revendications précédentes, comprenant en outre un mécanisme de commutation (170) configuré pour la fourniture d'un signal de commande au module de mesure (300) pour la commutation du module de mesure entre un mode main gauche et un mode main droite.

10. Dispositif de capteur selon la revendication 9, dans lequel le module de mesure (300) est configuré pour la détermination d'une position d'un doigt de la main gauche sur la base de l'un ou de chaque signal électrique et du signal de commande lors d'une présence dans le mode main gauche, et pour la détermination d'une position d'un doigt de la main droite sur la base du ou de chaque signal électrique et du signal de commande lors d'une présence dans le mode main droite.

11. Dispositif de capteur selon la revendication 9 ou 10, dans lequel le mécanisme de commutation est un commutateur, un bouton ou un capteur disposé sur la portion de poignée ou dans celle-ci.

12. Dispositif de capteur selon l'une quelconque des revendications 9 à 11, dans lequel le mécanisme de commutation est actionné lors de la connexion de la portion de montage sur main (110) à la portion de poignée (120).
